# EUROPÄISCHE PATENTANMELDUNG

(11) **EP 0 943 698 A2**
(43) Veröffentlichungstag der Anmeldung: **22.09.1999**
(21) Anmeldenummer: 98122276.3
(22) Anmeldetag: 24.11.1998
(51) Int. Cl.: C23C 14/56, C23C 14/10

(54) **Verfahren und Vorrichtung zum Transportieren von zylindrischen Substraten**

(30) Priorität: 19.02.1998 DE 19807032
(71) Anmelder: Leybold Systems GmbH, 63450 Hanau (DE)
(72) Erfinder: Baumecker, Tomas, 63486 Bruchköbel (DE); Grimm, Helmut Dr., 64291 Darmstadt (DE); Henrich, Jürgen, 63694 Limeshain (DE); Michael, Klaus Dr., 63571 Gelnhausen (DE); Rödling, Gert, 63179 Obertshausen (DE); Ulrich, Jürgen, 61137 Schöneck (DE)

(57) **Zusammenfassung**

Zum Beschichten von Substraten (17,18,20,21,22) in einer Vakuumbeschichtungskammer (2) werden die Substrate über eine Schleuse in die Beschichtungskammer (2) eingebracht und entlang eines Transportweges vor den eine Beschichtungswolke erzeugenden Beschichtungsquellen (50a,b,c,d) verfahren. Hierzu werden die Substrate (17,18,20,21,22) mittels an einem Transportband (9) verfahrbar angeordneter Haltevorrichtungen (24) nacheinander während mindestens zweier Beschichtungsphasen an den Beschichtungsquellen (50a,b,c,d) vorbeigeführt. Während der einen Beschichtungsphase werden die Substrate (17,18,20,21,22) entlang einer Transportrichtung T₃ derartig zu den Beschichtungsquellen (50a,b,c,d) ausgerichtet, daß im wesentlichen der Substratboden des zylindrischen Substrates beschichtet wird. Während der anschließenden zweiten Beschichtungsphase werden die Substrate in einer zur Transportrichtung T₃ entgegengesetzten Richtung T₄ vor den Beschichtungsquellen (50a,b,c,d) entlang gefahren, wobei die Substrate (17,18,20,21,22) derartig ausgerichtet sind, daß im wesentlichen die Zylindermantelfläche beschichtet wird. Durch das Verfahren werden die Substrate (17,18,20,21,22) nacheinander in identischer Weise und unabhängig von während des Beschichtungsprozesses möglichen Substratpositionen in Bezug zu den Beschichtungsquellen (50a,b,c,d) beschichtet. Mit dem Verfahren werden flaschenförmige Behälter, insbesondere Kunststoffflaschen mit einer Gas- bzw. Flüssigkeitsbarriereschicht bedampft. Die Beschichtungsquellen (50a,b,c,d) bestehen aus thermischen Verdampfern und/oder Plasmakathodensputterquellen.

## Beschreibung

Die Erfindung betrifft ein Verfahren und eine Vorrichtung zum gleichmäßigen Beschichten von zylindrisch geformten Substraten mit Schichtmaterial, welches aus einer Materialwolke auf den Substraten abgeschieden wird, wobei die zu beschichtenden Substrate in die Materialwolke eingebracht werden.

Gattungsgemäße Beschichtungsverfahren sind z.B. zum Aufbringen von optisch aktiven Schichten auf optischen Elementen bekannt. Bei diesen Verfahren wird das zu beschichtende Substrat innerhalb einer Vakuumbeschichtungskammer vor eine Beschichtungsquelle positioniert. Das von der Beschichtungsquelle als Materialwolke emittierte Schichtmaterial wird auf den der Beschichtungsquelle zugewandten Flächen des Substrats abgeschieden. Um z. B. die vorgenannten optischen Gläser beidseitig zu beschichten ist es erforderlich, den Beschichtungsvorgang zu unterbrechen, die Substrate um 180° zu wenden und den Beschichtungsvorgang anschließend fortzusetzen. Der Beschichtungsprozeß von mehrflächigen Substraten erfolgt bei den üblichen Verfahren sukzessiv für jede Substratfläche einzeln, wobei zum Repositionieren der Substrate vor den Beschichtungsquellen die Beschichtungskammern jedes Mal wieder zu öffnen sind. Hierzu sind die Beschichtungskammern zu belüften bzw. für die Durchführung des anschließenden Beschichtungsprozesses wieder zu evakuieren, was die bekannten Verfahren insbesondere bei der Beschichtung großer Stückzahlen identischer Substrate zeitaufwendig und kostenintensiv macht.

Der Erfindung liegt daher die Aufgabe zugrunde, ein Verfahren der eingangs beschriebenen Gattung anzugeben, bei welchem die Beschichtung von großen Serien von Substraten, welche eine mehrflächige Oberfläche aufweisen, ohne Unterbrechung des Beschichtungsvorganges zur Reposition der zu beschichtenden Substratflächen ermöglicht wird. Weiterhin soll eine Vorrichtung zum Beschichten von Substraten geschaffen werden, mittels welcher das aufgabengemäße Verfahren durchführbar ist.

Die Lösung der gestellten Verfahrensaufgabe erfolgt erfindungsgemäß dadurch, daß die zu beschichtenden Substrate zum Abscheiden des Schichtmaterials in die Materialwolke eingebracht werden, wobei der Beschichtungsprozeß mindestens zwei einen Beschichtungszyklus bildende, zeitlich aufeinander folgende Beschichtungsphasen umfaßt. Während der einen, vorzugsweise der ersten Beschichtungsphase wird das einzelne Substrat derartig zur Beschichtungsquelle räumlich ausgerichtet, daß im wesentlichen dessen Zylindermantelfläche beschichtet wird. Während der anderen, vorzugsweise der zweiten Beschichtungsphase wird das Substrat vor einer Beschichtungsquelle derartig räumlich ausgerichtet, daß im wesentlichen mindestens ein Zylinderboden des Substrats beschichtet wird. Durch die unterschiedliche Orientierung des Substrats während der beiden Beschichtungsphasen wird das Substrat gleichmäßig im Seiten- und Bodenbereich mit einer zusammenhängenden Flächenschicht überzogen. Die erste und die zweite Beschichtungsphase erfolgen in der Beschichtungskammer unmittelbar nacheinander, ohne daß die Beschichtungskammer zur Repositionierung der Substrate zwischen den beiden Beschichtungsphasen belüftet wird. Bei dem erfindungsgemäßen Verfahren erfolgt die vollständige Beschichtung des Substrats somit vorteilhaft in kürzest möglicher Zeit, wodurch der gesamte Beschichtungsprozeß kostengünstig durchgeführt werden kann. Dieser Vorteil ist von besonderer Bedeutung, wenn eine große Anzahl von Substraten zu beschichten ist.

Das erfindungsgemäße Verfahren gestaltet sich insbesondere mit den Merkmalen des Anspruchs 2 kostengünstig, nämlich indem die Substrate während der ersten und zweiten Beschichtungsphase durch dieselbe Beschichtungsquelle beschichtet werden. Dies hat den Vorteil, daß lediglich eine Beschichtungsquelle benötigt wird, was das Verfahren kostengünstig macht. Gemäß den Merkmalen des Patentanspruchs 3 werden die Substrate während des Beschichtungszyklus im konstanten Abstand vor der oder den Beschichtungsquellen entlang verfahren. Durch diese Maßnahme ist gewährleistet, daß jedes einzelne Substrat in gleicher Weise der Materialwolke ausgesetzt wird und der Schichtauftrag auf den Substraten nicht von unterschiedlichen Positionen der Substrate in Bezug zu der oder den Beschichtungsquellen abhängig ist. Da die Emission der Materialwolke aus der Beschichtungsquelle nicht isotrop stattfindet, werden durch dieses Merkmal insbesondere unterschiedliche Schichtdicken auch infolge der räumlichen Dichteunterschiede in der Materialwolke vorteilhaft vollständig ausgeglichen.

Weiterhin wird vorgeschlagen, die erste Beschichtungsphase mit der zweiten Beschichtungsphase zu vertauschen (Anspruch 4), wodurch der Beschichtungsablauf des erfindungsgemäßen Verfahrens in gewünschter Weise flexibel handhabbar ist.

Die Substrate werden mittels eines Transportbandes, an welchem vorzugsweise im äquidistanten Abstand zueinander einzelne Substrathaltevorrichtungen mit jeweils einzeln verschwenkbaren Greifvorrichtungen vorgesehen sind, vor der oder den Beschichtungsquellen verfahren. Hierbei erstreckt sich das Transportband über einen Transportweg, entlang dessen die Substrate transportiert werden. Mittels der verschwenkbaren Greifvorrichtungen wird die räumliche Lage der Substrate in Bezug zur Beschichtungsquelle in Abhängigkeit der Beschichtungsposition und/oder dem Transportweg der Substrate eingestellt.

Als Transportband ist vorgesehen, ein Endlostransportband zu verwenden, welches sich entlang eines in sich zurückführenden, geschlossenen Transportweges erstreckt. Der Transportweg der Substrate in der Beschichtungskammer wird gemäß Anspruch 6 so gewählt, daß die Substrate während der einen Beschichtungsphase die Materialwolke in entgegengesetzter Transportrichtung zur Transportrichtung der Substrate während der zugeordneten anderen Beschichtungsphase durchlaufen. Durch diese Maßnahme wird erreicht, daß einerseits die Verdampferkeule der Materialwolke effektiv ausgenutzt wird, da sich die räumliche Anordnung der Substrate der räumlichen Ausdehnung der Keulenform der Materialwolke derartig anpassen läßt, daß sich die Materialwolke ausschließlich auf die zu beschichtenden Substraten und nicht auf anderen Oberflächen in der Beschichtungskammer niederschlägt. Durch diese Maßnahme wird eine effektive Ausnutzung und Materialverbrauch des in der Beschichtungsquelle vorhandenen Reservoirs des Beschichtungsmaterials erzielt.

Weiterhin erlaubt die gegenläufige Ausrichtung des Transportweges während der unterschiedlichen Transportphasen eine flächenkompakte Anordnung des Transportbandes und damit vorteilhaft eine kompakte räumliche Ausbildung der Beschichtungskammer.

Zum Abscheiden mehrerer bzw. einzelner dickerer Schichten wird vorgeschlagen, die Substrate in derselben Vakuumbeschichtungskammer unmittelbar aufeinanderfolgenden Beschichtungszyklen auszusetzen.

Um die Schichtdicken auf den Substraten in Abhängigkeit der zu beschichtenden Substratflächen optimal auszubilden, werden die Substrate während der einen, vorzugsweise der zweiten Beschichtungsphase in einem unterschiedlichen Abstand zur Beschichtungsquelle und auf der von der Beschichtungsquelle abgewandten Seite der anderen, vorzugsweise die erste Beschichtungsphase durchlaufenden Substrate angeordnet. Aufgrund der abstandsabhängigen Dichte der Materialwolke wird das Beschichtungsmaterial mit unterschiedlicher abstandsabhängiger Rate auf dem Substrat abgeschieden, wodurch in gewünschter Weise unterschiedlich dicke Schichten erzeugt werden.

Die Schichtdicken auf den unterschiedlichen Substratflächen können auch mit den Verfahrensmerkmalen nach Anspruch 10 eingestellt werden, indem die Substrate während der einen Beschichtungsphase teilweise durch die die andere Beschichtungsphase durchlaufenden Substrate abgeschirmt werden. Entsprechend dem eingestellten Abstimmungsgrad können damit in einfacher Weise die effektiven Beschichtungszeiten und damit Schichtdicken für die unterschiedlichen Beschichtungsflächen des Substrats gewählt werden.

Mit dem erfindungsgemäßen Verfahren ist es möglich, SiO₂-aufweisende Schichten auf einzelnen Substraten abzuscheiden. Derartige, typischerweie zwischen 20 nm und 200 nm dicke, SiO₂-haltige Schichten sind optisch transparent und für den Durchtritt gasförmiger und/oder flüssiger Substanzen sperrend. Derartige Schichten werden mit dem Verfahren z. B. mittels Verdampferquellen und/oder Sputterkathodenquellen erzeugt (siehe Anspruch 12). Vorzugsweise werden derartige Sperrschichten auf Kunststoffsubstraten, insbesondere Kunststoffbehältern abgeschieden, die z. B. als Getränke aufnehmende Flaschen dienen. Durch die Sperrschicht soll verhindert werden, daß die in der Getränkeflüssigkeit gelösten Gase, wie z. B. CO₂, aus dem Behältervolumen entweichen.

Zur Durchführung des Verfahrens wird eine Vorrichtung gemäß Patentanspruch 13, welche mindestens eine Beschichtungskammer, vorzugsweise eine Vakuumbeschichtungskammer, sowie eine Beschichtungsquelle umfaßt, vorgeschlagen. In der Vakuumbeschichtungskammer ist ein Transportband, vorzugsweise ein Endlostransportband zum Transport der Substrate entlang eines Transportweges angeordnet. Die entlang des Transportweges mit dem Transportband an Haltevorrichtungen beförderten Substrate werden durch eine von der Beschichtungsquelle erzeugte Materialwolke bewegt. Das Transportband durchfährt die Materialwolke während der einen, vorzugsweise einer ersten Beschichtungsphase in einer Vorzugsrichtung, wobei die Substrate mit ihrer zu beschichtenden Fläche zur Beschichtungsquelle hin orientiert sind. Zur Beschichtung weiterer Substratflächen werden die Substrate während der anderen, vorzugsweise einer zweiten Beschichtungsphase derartig zur Beschichtungsquelle den Transportweg durchlaufend orientiert, daß das Schichtmaterial sich im wesentlichen auf dieser Fläche niederschlägt. Hierbei durchfährt das Substrat einen dem Transportweg der ersten Beschichtungsphase entgegengerichteten Transportweg.

Weitere vorteilhafte merkmalsmäßige Ausgestaltungen der Erfindung sind in den übrigen Unteransprüchen angegeben.

Nachfolgend wird das erfindungsgemäße Verfahren und die vorgeschlagen Vorrichtung zur Durchführung des Verfahrens anhand eines in Figuren dargestellten Ausführungsbeispiels näher erläutert. Es zeigen:
- Fig. 1: einen horizontalen Längsschnitt durch eine Beschichtungskammer zum Beschichten von Substraten mit zugeordneter Schleusen- und Transferkammer,
- Fig. 2: eine Querschnittsansicht entlang der Schnittlinie A-A' in Fig. 1,
- Fig. 3: eine Querschnittsansicht entlang der Schnittlinie B-B' in Fig. 1,
- Fig. 4: eine Querschnittansicht entlang der Schnittlinie C-C' in Fig. 1,
- Fig. 5: einen Ausschnitt der in Fig. 1 dargestellten Beschichtungskammer mit Transferkammer in vergrößerter Darstellung,
- Fig. 6: einen Ausschnitt der in Fig. 1 dargestellten Beschichtungskammer mit Umlenkstation in vergrößerter Darstellung,
- Fig. 7: eine Längsschnittansicht entlang der Schnittlinie D-D' in Fig. 1 und
- Fig. 8: eine perspektivische Darstellung des Transportweges der Substrate in einer in Längsrichtung aufgeschnittenen Beschichtungskammer.

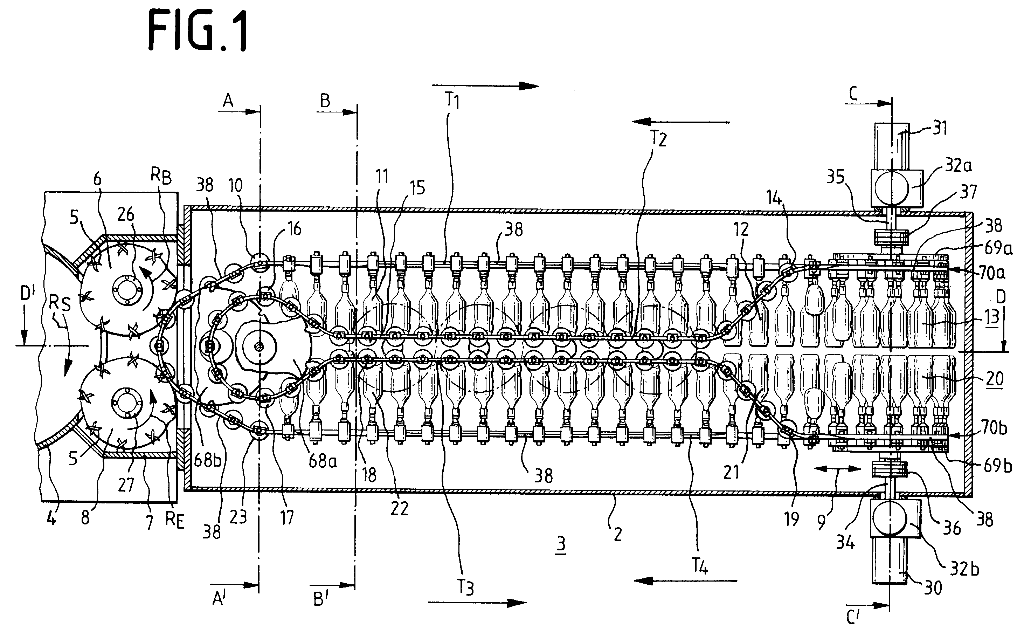

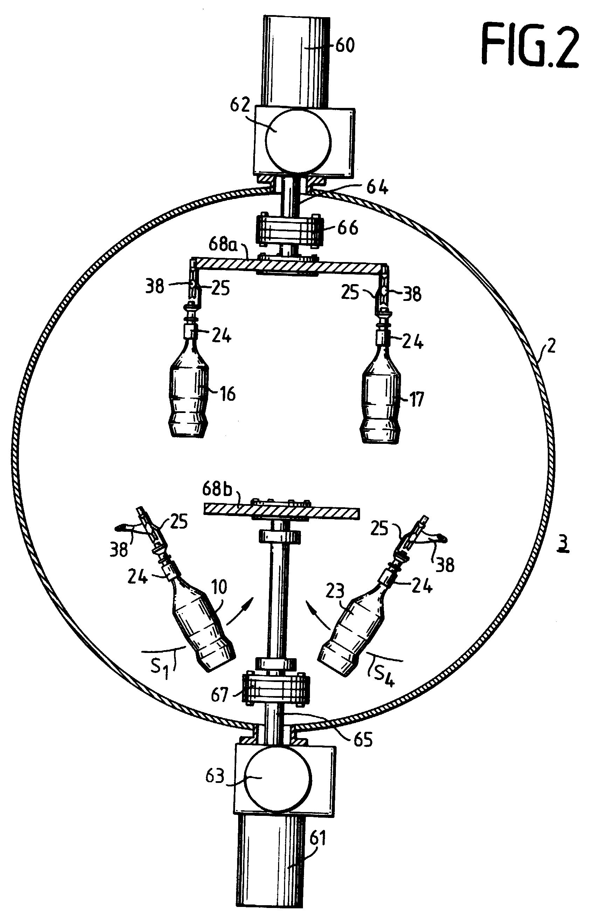

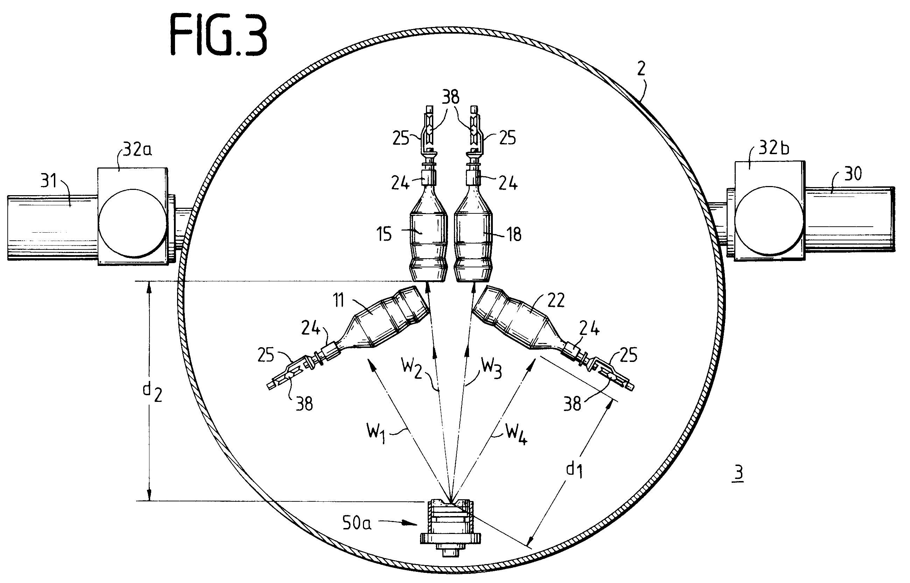

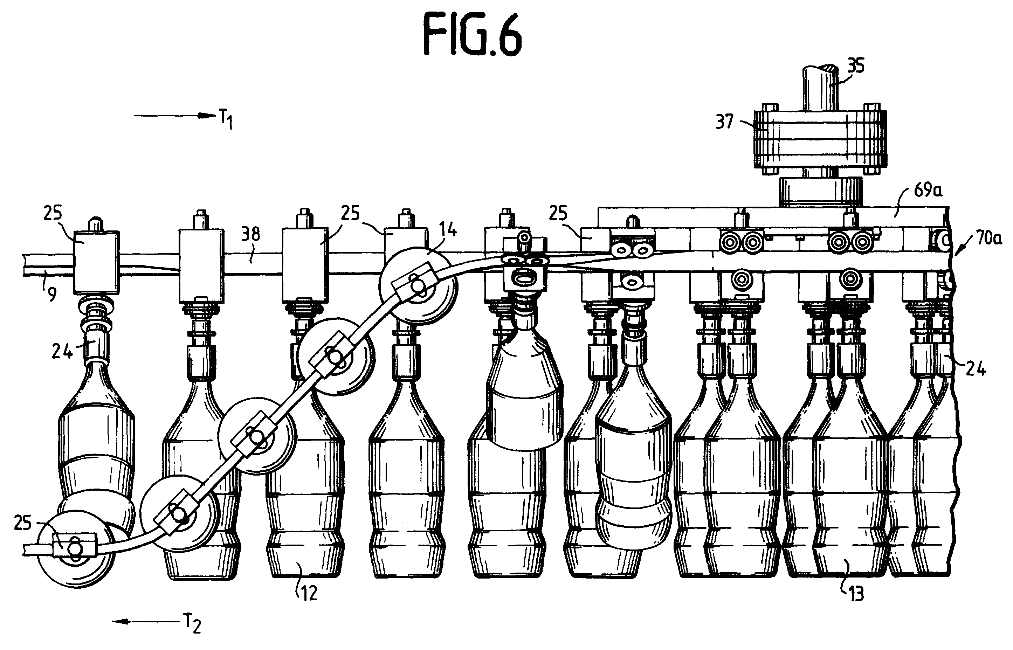

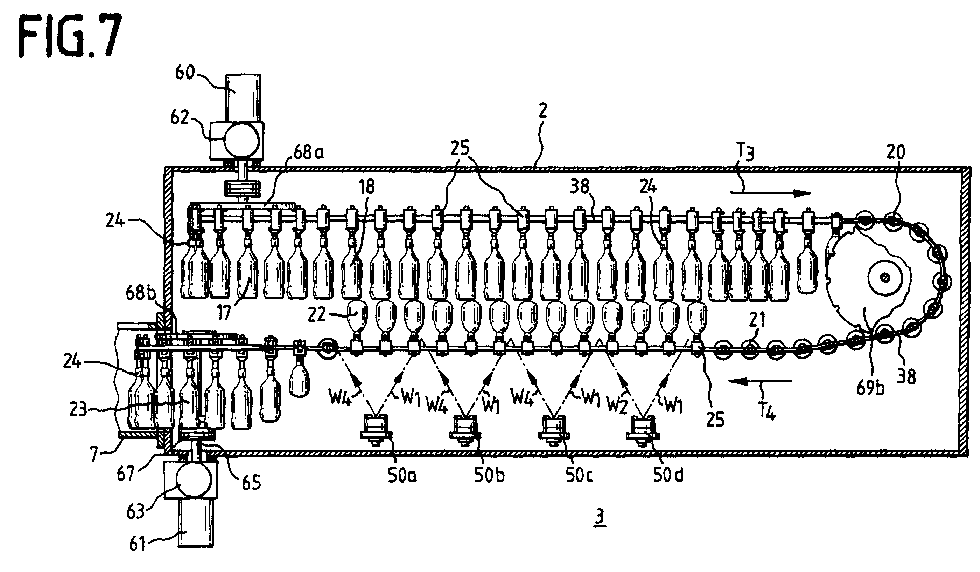

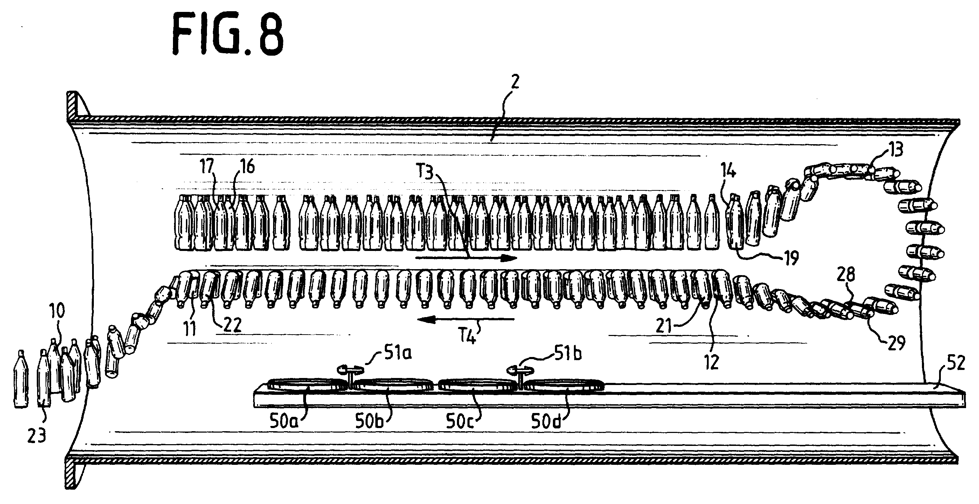

Die in Fig. 1 dargestellte Beschichtungsvorrichtung zum Beschichten von zylindrischen Substraten 10-23,28,29 besteht im wesentlichen aus einer Beschichtungskammer 2 und einer stirnseitig zugeordneten Transferkammer 7, durch welche die zu beschichtenden Substrate 10-23,28,29 von einer Schleuse 4 in die Beschichtungskammer 2 transportiert werden. Das Innere der Beschichtungskammer 2 ist auf einen für vakuumgestützte Beschichtungsverfahren typischen maximalen Unterdruck von 10⁻³ mbar - 10⁻⁶ mbar mittels in den Zeichnungen nicht dargestellter, bekannter Vakuumpumpenanordnungen über Pumpstutzen an der Beschichtungskammer abpumpbar. Die Druckdifferenz zwischen dem einen höheren Druck, z. B. Normaldruck aufweisenden Außenraum 3 und dem Inneren der Beschichtungskammer 2 wird über die atmosphärisch dichtende Schleusenkammer 4 aufrecht erhalten. Die zu beschichtenden Substrate 10-23,28,29 werden in der Schleuse 4 in nicht dargestellten, vorzugsweise einzelnen Schleusenkammern in Umlaufrichtung R_{S} zur Entnahmevorrichtung 6, welche die Substrate aus den Schleusenkammern entnimmt, kontinuierlich herangeführt. In der Entnahmevorrichtung 6 sind mehrere, um eine Achse 26 in der Drehrichtung R_{B} rotierende Greifer 5 angeordnet. Die Umlaufgeschwindigkeit der einzelnen Greifer 5 entspricht dabei der Umlaufgeschwindigkeit der in der Schleuse 4 herangeführten Substrate 10-23,28,29. Die Substrate 10-23,28,29 werden von den Greifern 5 erfaßt und aus den Schleusenkammern ausgebracht. Anschließend werden die Substrate 10-23,28,29 nach einer Drehung der Greifer 5 in Drehrichtung R_{B} von ca. 180° um die Achse 26 in den Transportweg eines Transportbandes 9 (siehe Fig. 2-4) eingeschleust. An dem z. B. als Schiene ausgebildeten Transportband 9 sind einzelne und durch eine Transportkette 38 miteinander verbundene Rollenschlitten 25 verfahrbar angeordnet. Mit den Rollenschlitten 25 ist jeweils ein substrataufnehmender Transportverschluß 24 verbunden, in welchen die Substrate 10-23,28,29 gehalten werden. Diese Transportverschlußvorrichtungen 24 dienen dazu, die Öffnung von z. B. behälterförmigen Substraten 10-23,28,29 dicht zu verschließen, um eine Erhöhung des Unterdrucks in der Beschichtungskammer 2 durch in den Behältern in die Beschichtungskammer 2 mitgeführtes und in dieser austretendes Atmosphärengas zu verhindern. Die in den Transportverschlußvorrichtungen 24 eingesetzten Substrate 10-23,28,29 werden auf dem Transportband 9 zunächst parallel zu in der Beschichtungskammer 2 angeordneten Beschichtungsquellen 50a,b,c,d in Transportrichtung T₁ verfahren (siehe Fig. 1,5,6). Hierbei durchfahren die Substrate 10-23,28,29 die von den Beschichtungsquellen 50a,b,c,d erzeugten Materialwolken 41,42,43,47, welche, wie in den Fig. 3 und 7 dargestellt, im wesentlichen als einzelne, jedoch teilweise überlappende Verdampfungskeulen ausgebildet sind, welche die räumliche Ausdehnung entlang der Trajektorien W₁,W₂,W₃,W₄ besitzen. Wie den Fig. 2,3,4,7,8 zu entnehmen ist, durchläuft das Transportband 9 die Beschichtungskammer 2 in zwei horizontal verlaufenden Ebenen, wobei sich die Transportrichtungen T₁,T₂,T₃,T₄ innerhalb derselben Transportebene über die Längsrichtung der Beschichtungskammer 2 umkehren. Während des gesamten Beschichtungsprozesses durchläuft ein zu beschichtendes Substrat 10-23,28,29 vier Transportrichtungen, nämlich die richtungsgleichen T₁ und T₃ sowie die hierzu entgegengerichteten T₂ und T₄ in der Richtungsfolge T₁-T₂-T₃-T₄.

Exemplarisch wird der Transportweg eines einzelnen Substrats 10, welches in den Fig. 1,2 und 5 dargestellt ist, verfolgt. Hierbei wird das Substrat 10 zunächst mittels der schwenkbaren Transportverschlüsse um ca. 120° gegen den Uhrzeigersinn in der Figurenaufsicht zu Fig. 2 in Schwenkrichtung S₁ verschwenkt. In dieser in den Fig. 3 und 7 dargestellten Bedampfungsposition durchfährt das Substrat 11 die Beschichtungskammer 2 in Längsrichtung, wobei das Substrat 11 im wesentlichen mit seiner Mantelfläche zu den Beschichtungsquellen 50a,b,c,d (siehe Fig. 3,7,8) ausgerichtet ist. Die z. B. zwischen den Trajektorien W₁ und W₂ (siehe Fig. 3,7) sich ausdehnende Beschichtungskeule erfaßt das Substrat 11 und beschichtet dieses fast ausschließlich auf dem Seitenbereich. Um eine homogene Rundumbeschichtung des Substrats 10-23,28,29 auf dem gesamten Transportweg 9 zu gewährleisten, werden die Substrate 10-23,28,29 während des gesamten Beschichtungszyklus um ihre Längsachse gedreht, wodurch der Behälterumfang den Beschichtungsquellen 50a,b,c,d gleichmäßig zugewandt wird.

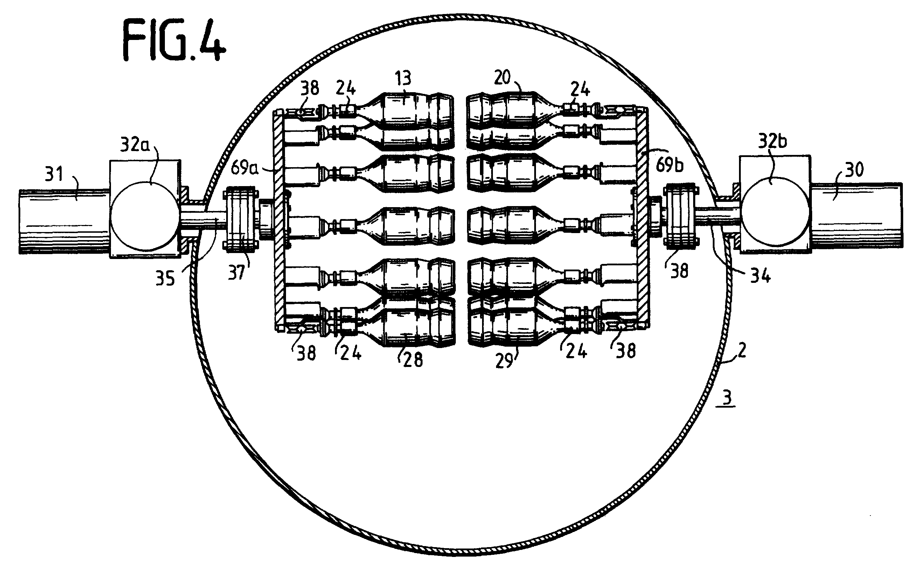

Nach Abschluß dieser ersten Beschichtungsphase entlang der Transportrichtung T₁ wird das nunmehr ausschließlich im Seitenbereich beschichtete Substrat 12 von seiner 120°-Position in eine horizontale Lage verschwenkt (siehe Fig. 4) und der Transportweg T₁ über eine Wendevorrichtung (31,32a,37,69a,70a) in entgegengesetzte Richtung T₂ umgelenkt. Anschließend werden die horizontal gelagerten Substrate 13 in eine vertikale Substratposition 14,15 überführt. Die Substrate 14,15 sind nunmehr mit ihrer zu beschichtenden Bodenfläche zu den Beschichtungsquellen 50a,b,c,d ausgerichtet, wodurch das Schichtmaterial im wesentlichen sich auf dem Substratboden niederschlägt. Der Transportweg T₂ dieser zweiten Beschichtungsphase führt zu einer 360°-Wendestation mit einem Triebstockrad 68a, in welcher die Substrate 16,17 (siehe Fig. 1,2) einem dritten Beschichtungsabschnitt mit einer Transportrichtung T₃ zugeführt werden, der einen zweiten Beschichtungszyklus einleitet.

Im diesem dritten Beschichtungsabschnitt durchlaufen die Substrate 18,21 den Transportweg in die Transportrichtung T₃ und werden hierbei parallel zu den den zweiten Beschichtungsabschnitt durchlaufenden Substraten 14,15 transportiert und der Substratboden beschichtet.

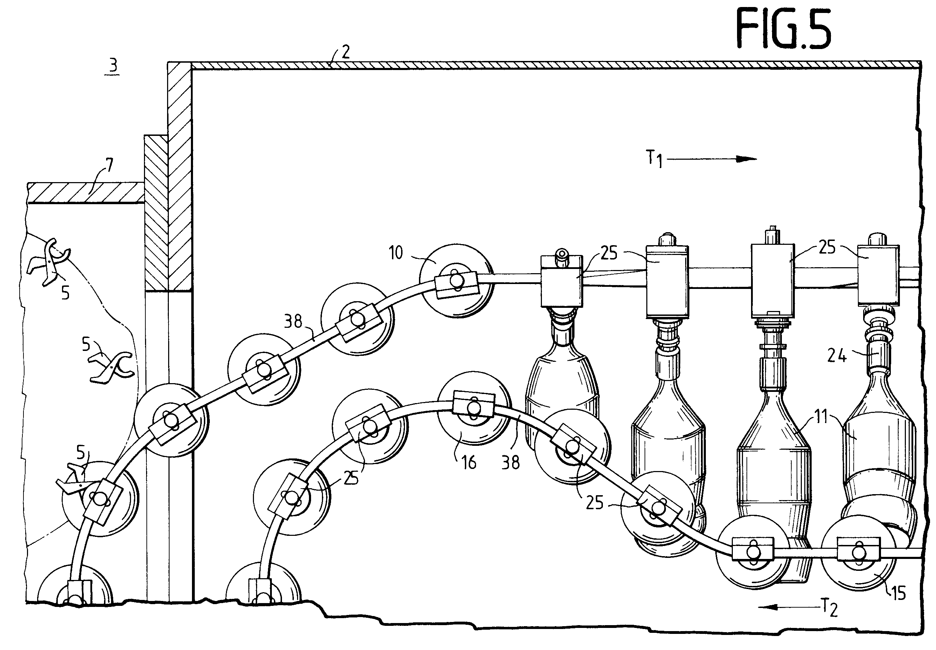

Im Anschluß an die dritte Beschichtungsphase werden die Substrate 10-23,28,29 wiederum über eine weitere Wendeeinrichtung 30,32b,34,36,69b,70b in ihrer Bewegungsrichtung umgedreht. Gleichzeitig werden die Substrate, wie in Fig. 5 und 7 dargestellt, aus ihrer vertikalen Position in die 120°-Schräglage verschwenkt, um die Substrate 21,22 mit ihrer zylindrischen Mantelfläche wieder zu den Beschichtungsquellen 50a,b,c,d auszurichten. Im Anschluß an diese vierte Beschichtungsphase werden die nunmehr vollständig beschichteten Substrate 22,23 der Übergabevorrichtung 8 in der Transferkammer 7 zugeführt. Analog wie beim Entnehmen der Substrate 10-23,28,29 aus den Schleusenkammern werden die Substrate mittels Greifern 5 vom Transportband 9 in die Schleusenkammern der Schleusenvorrichtung 4 übergeben und mittels dieser in den Atmosphärenaußenraum 1 geschleust. Der gesamte Substrattransport und der Beschichtungsprozeß erfolgen kontinuierlich.

Das Transportband 9 wird an den vier Wendestationen jeweils von einem konzentrisch zu einem zugeordneten Umlenkrad angeordneten Antriebsrad 68a,68b,69a,69b, welches jeweils über eine eine Kupplung 36,37,66,67 aufweisende Antriebsachse 34,35,64,65, die über ein Getriebe 32a,32b,62,63 von einem Motor 30,31,60,61 gedreht wird, angetrieben. Die Antriebsräder 68a,68b,69a,69b sind vorzugsweise als Triebstockräder ausgebildet, welche mit entsprechenden am Transportband 9 befestigten Vorschubelementen zusammenwirken.

Die Antriebseinrichtungen des Transportbandes 9 sind jeweils zueinander achsparallel und gegenüberliegend in Bezug zu den Längssymmetrieebenen der Beschichtungskammer 2 in den jeweils endseitig der Beschichtungskammer 2 angeordneten Wendeeinrichtungen vorgesehen.

### Bezugszeichenliste

- 2: Beschichtungskammer, Vakuumbeschichtungskammer
- 3: Außenraum
- 4: Schleuse, Vakuumschleuse
- 5: Greifer
- 6: Entnahmevorrichtung, Übergabestation
- 7: Transferkammer
- 8: Übergabevorrichtung
- 9: Transportband, Endlostransportband, Transportweg
- 10: Substrate, Behälter / unbeschichtet
- 11: Substrat
- 12: Substrat, 1. Beschichtungsphase
- 13: Substrat, 1. Umlenkphase
- 14: Substrat, 2. Beschichtungsphase
- 15: Substrat, 2. Beschichtungsphase
- 16: Substrat, 2. Umlenkphase
- 17: Substrat, 2. Umlenkphase
- 18: Substrat, 3. Beschichtungsphase
- 19: Substrat, 3. Beschichtungsphase
- 20: Substrat, 3. Umlenkphase
- 21: Substrat, 4. Beschichtungsphase
- 22: Substrat, 4. Beschichtungsphase
- 23: Substrat, beschichtet
- 24: Transportverschluß, Haltevorrichtung
- 25: Rollenschlitten
- 26: Achse
- 27: Achse
- 28: Substrat
- 29: Substrat
- 30: Motor
- 31: Motor
- 32a,b: Getriebe
- 33: Getriebe
- 34: Antriebswelle
- 35: Antriebswelle
- 36: Kupplung
- 37: Kupplung
- 38: Transportkette
- 40: Beschichtungsquelle
- 41: Beschichtungswolke
- 42: Beschichtungsquelle
- 43: Beschichtungswolke
- 44: Beschichtungsquelle
- 45: Beschichtungswolke
- 46: Beschichtungsquelle
- 47: Beschichtungswolke
- 50a,b,c,d: Beschichtungsquelle
- 51a,b: Gaseinlaß
- 52: Quellenhalterung
- 60: Motor
- 61: Motor
- 62: Getriebe
- 63: Getriebe
- 64: Antriebswelle
- 65: Antriebswelle
- 66: Kupplung
- 67: Kupplung
- 68a,b: Antriebsrad, Triebstockrad
- 69a,b: Antriebsrad, Triebstockrad
- 70a,b: Umlenkrad
- 80: Umlenkrad
- 81: Umlenkrad
- T₁: Transportrichtung
- T₂: Transportrichtung
- T₃: Transportrichtung
- T₄: Transportrichtung
- R_{S}: Umlaufrichtung/Schleuse
- R_{B}: Drehrichtung/Übergaberad
- R_{E}: Drehrichtung/Übergaberad
- S₁: Schwenkrichtung
- S₂: Schwenkrichtung
- W₁: Verdampfungskeule, Trajektorie
- W₂: Verdampfungskeule, Trajektorie
- W₃: Verdampfungskeule, Trajektorie
- W₄: Verdampfungskeule, Trajektorie
- d₁: Beschichtungsabstand
- d₂: Beschichtungsabstand
- A-A': Schnittlinie
- B-B': Schnittlinie
- C-C': Schnittlinie
- D-D': Schnittlinie

## Patentansprüche

1. Verfahren zum Beschichten von zylindrisch geformten Substraten (10-23,28,29) mit Schichtmaterial, wobei mindestens eine Beschichtungsquelle (50a,b,c,d) vorgesehen ist, welche eine das Beschichtungsmaterial enthaltende Materialwolke (41,43,45,47) erzeugt, und wobei die zu beschichtenden Substrate (10-23,28,29) zum Abscheiden des Schichtmaterials in die Materialwolke eingebracht werden, wobei der Beschichtungsprozeß mindestens zwei, einen Beschichtungszyklus bildende, zeitlich aufeinander folgende Beschichtungsphasen umfaßt, und daß
- während der einen Beschichtungsphase das einzelne Substrat (11,12,21,22) derartig zur Beschichtungsquelle (50a,b,c,d) räumlich ausgerichtet ist, daß im wesentlichen die Zylindermantelfläche des Substrats (11,12,21,22) beschichtet wird und daß
- während der anderen Beschichtungsphase das einzelne Substrat (14,15,16,17,18,19) derartig zur Beschichtungsquelle (50a,b,c,d,) räumlich ausgerichtet ist, daß im wesentlichen mindestens ein Zylinderboden des Substrats (14,15,16,17, 18,19) mit dem Schichtmaterial beschichtet wird, wodurch auf dem Substrat (10-23,26,27) eine zusammenhängende Flächenschicht abgeschieden wird.

2. Verfahren nach Anspruch 1, **dadurch gekennzeichnet**, daß die Substrate (10-16) während der einen Beschichtungsphase im wesentlichen mit ihrer Mantelfläche zur Beschichtungsquelle (50a,b,c,d) ausgerichtet sind und daß während der anderen Beschichtungsphase die Substrate (17-23) mit dem zu beschichtenden Zylinderboden zur Beschichtungsquelle (50a,b,c,d) ausgerichtet sind und durch dieselbe Beschichtungsquelle (50a,b,c,d) beschichtet werden.

3. Verfahren nach Anspruch 1 und/oder Anspruch 2, **dadurch gekennzeichnet**, daß die Substrate (10-23,26,27) während der einen, vorzugsweise der ersten und während der anderen, vorzugsweise der zweiten Beschichtungsphase in Bezug zur Beschichtungsquelle (50a,b,c,d) mit konstantem Abstand (d₁,d₂) vor dieser entlang verfahren werden, wodurch jedes Substrat die Beschichtungswolke (41,43,45,47) in gleicher Weise durchfährt.

4. Verfahren nach mindestens einem der Ansprüche 1 bis 3, **dadurch gekennzeichnet**, daß der Abstand (d₁) während der einen Beschichtungsphase von dem Abstand (d₂) während der anderen Beschichtungsphase abweicht.

5. Verfahren nach mindestens einem der Ansprüche 1 bis 4, **dadurch gekennzeichnet**, daß die eine, vorzugsweise die erste Beschichtungsphase mit der anderen, vorzugsweise der zweiten Beschichtungsphase vertauscht wird.

6. Verfahren nach mindestens einem der Ansprüche 1 bis 5, **dadurch gekennzeichnet**, daß zum Verfahren der Substrate (10-23,26,27) vor der Beschichtungsquelle (50a,b,c,d) während der Beschichtungsphasen ein Transportband (9), vorzugsweise ein Endlostransportband vorgesehen ist, an welchem, vorzugsweise im äquidistanten Abstand zueinander, einzelne Haltevorrichtungen (24,25), vorzugsweise mit jeweils einzeln verschwenkbaren Haltevorrichtungen (24), zur Aufnahme der einzelnen Substrate (10-23,26,27) vorgesehen sind, und wobei das Transportband (9) sich entlang eines vorzugsweise in sich zurückführenden Transportweges erstreckt.

7. Verfahren nach mindestens einem der Ansprüche 1 bis 6, **dadurch gekennzeichnet**, daß die Transportrichtung (T₁,T₃) der Substrate (10,11,12; 17,18,19) während der einen Beschichtungsphase entgegengerichtet zur Transportrichtung (T₂,T₄) der Substrate (14,15,16; 21,22,23) während der zugeordneten anderen Beschichtungsphase verläuft.

8. Verfahren nach mindestens einem der Patentansprüche 1 bis 7, **dadurch gekennzeichnet**, daß der Beschichtungsprozeß mindestens zwei in derselben Vakuumbeschichtungskammer (2) unmittelbar aufeinanderfolgende Beschichtungszyklen umfaßt.

9. Verfahren nach mindestens einem der Ansprüche 1 bis 8, **dadurch gekennzeichnet**, daß die Substrate (13,14,15,16,17,18,19,20) während der einen, vorzugsweise der zweiten Beschichtungsphase auf der von der Beschichtungsquelle (50a,b,c,d) abgewandten Seite der anderen, vorzugsweise die erste Beschichtungsphase durchlaufenden Substrate (10,11,12; 21,22,23) angeordnet werden.

10. Verfahren nach mindestens einem der Ansprüche 1 bis 9, **dadurch gekennzeichnet**, daß die freie Sichtverbindung zwischen der Beschichtungsquelle (50a,b,c,d) und den die eine, vorzugsweise die zweite Beschichtungsphase durchlaufenden Substraten (13,14,15,16,17, 18,19,20) durch die die andere, vorzugsweise die erste Beschichtungsphase durchlaufenden Substrate (10,11,12; 21,22,23) teilweise abgeschirmt wird, wodurch gleichzeitig Substrate (13,14,15,16,17,18,19,20) auf ihrer Zylindermantelfläche und andere Substrate (10,11,12; 21,22,23) auf ihrem Substratboden beschichtet werden.

11. Verfahren nach mindestens einem der Ansprüche 1 bis 10, **dadurch gekennzeichnet**, daß auf den Substraten (10-23,26,27) eine für den Durchtritt gasförmiger und/oder flüssiger Substanzen undurchlässige Sperrschicht, vorzugsweise SiO₂ enthaltendes Schichtmaterial abgeschieden wird.

12. Verfahren nach mindestens einem der Ansprüche 1 bis 11, **dadurch gekennzeichnet**, daß der Beschichtungsprozeß mittels einer Verdampferquelle (50a,b,c,d) und/oder einer Sputterkathodenquelle (50a,b,c,d) durchgeführt wird.

13. Vorrichtung zur Durchführung des Verfahrens nach mindestens einem der Ansprüche 1 bis 12 mit einer Beschichtungskammer (2), vorzugsweise einer Vakuumbeschichtungskammer (2), in welcher mindestens eine Beschichtungsquelle (50a,b,c,d) angeordnet ist, **dadurch gekennzeichnet**, daß ein Transportband (9), vorzugsweise ein Endlostransportband zum Transport von Substraten (10-23,28,29) vorgesehen ist, wobei das Transportband (9) derartig räumlich in Bezug zur Beschichtungsquelle (50a,b,c,d) angeordnet ist, daß auf die am Transportband (9) gehaltenen Substrate (10-23,28,29) während zwei in zeitlicher Abfolge aufeinander folgender Beschichtungsphasen eine zusammenhängende Flächenschicht aus der von der Beschichtungsquelle (50a,b,c,d,) erzeugten Materialwolke abscheidbar ist, wobei die Substrate (10-23,28,29) während der einen Beschichtungsphase im wesentlichen mit ihrer Zylindermantelfläche und während der anderen Beschichtungsphase mit mindestens einem Zylinderboden zur Beschichtungsquelle (50a,b,c,d) ausrichtbar sind.

14. Vorrichtung nach Anspruch 13, **dadurch gekennzeichnet**, daß die Beschichtungsquelle (50a,b,c,d) aus einer das Schichtmaterial verdampfenden Quelle (50a,b,c,d) und/oder aus einer das Schichtmaterial zerstäubenden Sputterkathodenquelle (50a,b,c,d) besteht, welche in einer Vakuumbeschichtungskammer (2) vorgesehen sind.

15. Vorrichtung zur Durchführung des Verfahrens nach Anspruch 13 und/oder 14, **dadurch gekennzeichnet**, daß der Abstand (d₁,d₂) zwischen der Beschichtungsquelle (50a,b,c,d) und den zu beschichtenden Substraten (10-23,28,29) vorzugsweise in Abhängigkeit der räumlichen Erstreckung der Substrate (10-23,28,29) einstellbar ist, wodurch das verdampfte und/oder zerstäubte, abzuscheidende Schichtmaterial (41,43,45,47) im wesentlichen ausschließlich auf den Substraten (10-23,28,29) abscheidbar ist.

16. Vorrichtung zur Durchführung des Verfahrens nach einem der Ansprüche 13 bis 15, **dadurch gekennzeichnet**, daß die Substrate (10-23,28,29) während der Beschichtungsphasen um ihre Zylinderlängsachse drehbar an dem Transportband (9) gehalten sind, wodurch die Substrate (10-23,28,29) gleichmäßig umlaufend auf ihrer äußeren Mantelfläche beschichtbar sind.
